# EUROPEAN PATENT APPLICATION

(11) **EP 0 623 948 A1**
(43) Date of publication of application: **09.11.1994**
(21) Application number: 93924820.9
(22) Date of filing: 12.11.1993
(51) Int. Cl.: H01L 21/22, H01L 21/205, H01L 21/324, H01L 21/00

(54) **LOAD LOCK CHAMBER FOR VERTICAL TYPE HEAT TREATMENT APPARATUS**

(30) Priority: 13.11.1992 JP 327614/92
(71) Applicant: ASM JAPAN K.K., Tokyo 206 (JP)
(72) Inventor: KYOGOKU, Mitsusuke, Tama-shi, Tokyo 206 (JP)
(74) Representative: de Bruijn, Leendert C.
(86) International application number: PCT/JP93/01660
(87) International publication number: WO 94/11898

(57) **Abstract**

The title chamber has no elevating device which requires the provision of lubricating oil which is a source of particles causing contamination in the chamber. Below a treatment chamber (1) an intermediate chamber (30) is arranged. A supporting stand (34) is provided below the boat table (6) for supporting the objects to be processed, which can be loaded into or unloaded from the treatment chamber (1) gastightly through the intermediate chamber (30). The supporting stand (34) is mounted on a movable member movable vertically by means of a ball screw (13'). A bellows (22) is mounted between the intermediate chamber (30) and the movable member (12').

## Description

### Technical Field

The present invention relates generally to a load locked vertical type heat treatment apparatus, and more specifically to a load lock chamber provided to a load locked vertical vertical type heat treatment apparatus.

### Background Art

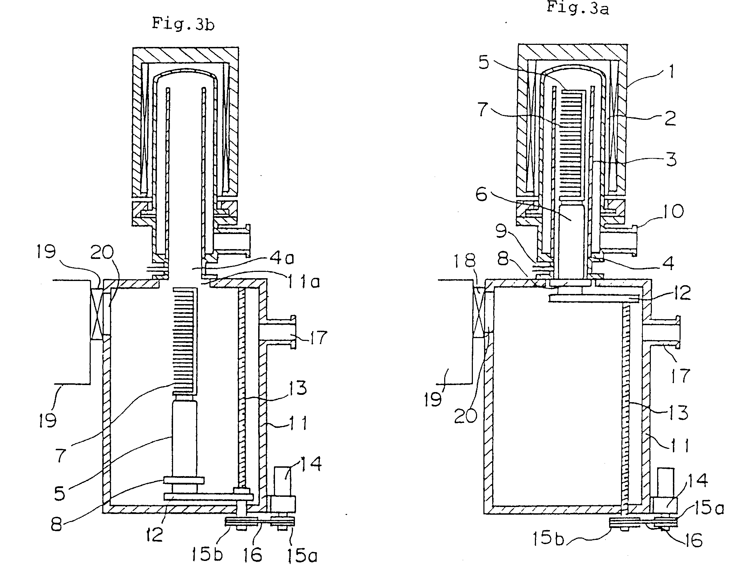

Fig.3(a) shows a partial cross sectional view of a load locked vertical type heat treatment apparatus. As shown in Fig.3, the load locked vertical type heat treatment apparatus is comprised of a treatment chamber 1 and an elevator chamber 11.

A reaction tube 2 is provided in the treatment chamber 1, and a compartment tube 3 is provided in the reaction tube 2. A manifold 4 which is provided with a gas inlet 9 for introducing a gas into the treatment chamber 1 and a gas outlet 10 for exhausting the gas is mounted below the treatment chamber 1. A heater is positioned around the reaction tube 2 so that the reaction tube 2, objects 7 inside the reaction tube and the like can be heated.

In the compartment tube 3, objects supporting boats 5 and a boat table 6 for supporting the boats 5 placing a plurality of objects 7, such as semiconductor wafers 7, in vertical direction with spaces between them are provided so that they can be loaded into and unloaded from the compartment tube 3 through the manifold 4. A treatment to objects 7 is to form a thin film by a chemical vapor deposition and is annealing or the like.

The elevator chamber 11 is connected below the treatment chamber 1 through the manifold 4. The elevator chamber 11 is communicated with the treatment chamber 1 through an opening 11a provided at the top of the elevator chamber 11 and an opening 4a (Fig.3b), of which diameter is smaller than the opening 11a (Fig.3), of the manifold 4. In the elevator chamber 11, untreated objects are placed to the objects supporting boats 5, or treated objects removed from the boats 5.

A sealing flange 8 with an outer diameter larger than the opening 4a and an inner diameter smaller than the opening 11a is mounted on the bottom surface of the boat table 6. The sealing flange 8 is contacted to a shoulder formed between the opening 4a and the opening 11a to open and close an interior space of the treatment chamber 1. By such opening and closing, the treatment chamber 1 is completely separated from an interior space of the elevator chamber 11.

A movable member 12 is horizontally extended and provided below the sealing flange 8, and a hole which is threaded is provided about its one end. A feed screw 13 screwed into the hole is extended upwardly and downwardly through the hole. The upper end of the feed screw 13 is mounted rotatably on an upper wall of the elevator chamber 11. The lower end is extended outside the elevator chamber 11 passing through the bottom of the elevator chamber 11 via an O-ring 13a by which the interior of the elevator chamber 11 is maintained in vacuum.

A pulley 15b is mounted about the end of the feed screw which is extended outside the elevator chamber 11, and the pulley 15b is connected to a pulley 15a provided about an end of a motor 14 provided on a side wall out side the elevator chamber 11 by a belt 16. Thus, by rotating the motor 14, the rotation is transferred to the feed screw, so that the movable member 12 is traveled upwardly and downwardly. Accordingly, the boat table 6 can be moved from the interior of the elevator chamber 11 to the treatment chamber 1, and vise versa. Whenever it is necessary to exhaust from the elevator chamber 11, the exhaust can be done through an outlet 17.

Fig.3b shows a partial cross sectional view of the heat treatment apparatus when the boat table 6 has been descended until the objects are also completely contained inside the elevator chamber 11. When placing objects to the objects supporting boats, the boat 5 is descended into the elevator chamber 11 as shown in Fig.3b, untreated objects are supplied to the boat 5 through an opening 20 and a gate valve 18. After the treatment, in the similar manner, the boat 5 is descended, treated objects are returned to a room 19.

However, in a load locked vertical type heat treatment apparatus of the art, means for elevating the boat table 6, that is the movable member 12, and the feed screw 13 are provided in the elevator chamber 11. Thus, particles are released by rotating the feed screw 13 and screwing the feed screw 13 into the movable member 12.

Also, when evacuating the interior of the elevator chamber 11 and elevating the boat table 6, it is required to put lubricating oil to engaging section between the feed screw and the boat table to make the elevation smoothly. Although the lubricating oil has low vapor pressure, an elevating structure inside the elevator chamber 11 is heated by radiation of objects and the like when the objects are unloaded from the treatment chamber 1 after the treatment, thereby evaporating the lubricating oil in the elevator chamber 11, and as a result, the objects are contaminated.

Moreover, in a vacuum load locked apparatus, because an interior of a chamber is always in a state of vacuum, it is very difficult to provide a mechanism for rotating a boat table for supporting objects.

Accordingly, an objective of the present invention is to provide a load lock chamber for a vertical type heat treatment apparatus which has no elevating device which requires the provision of lubricating oil which is a source of particles causing contamination in the elevator chamber.

Another objective of the present invention is to provide the load lock chamber for the vertical type heat treatment apparatus which can rotate a boat table supporting objects from the exterior.

### Disclosure of the Invention

In order to accomplish the above objectives, a load lock chamber for a vertical type heat treatment apparatus of the present invention is a load lock chamber which can be freely expanded in vertical direction and is arranged below a treatment chamber of the vertical type heat treatment apparatus and can gastightly load supporting means for supporting objects into the apparatus and unload the supporting means from the apparatus through the lower part of the apparatus, and the load lock chamber is expanded by elevating means provided outside the load lock chamber. The supporting means is mounted in the load lock chamber.

The load lock chamber may be comprised of two chamber sections such as an upper and a lower chamber section, of which sizes are different, and which are connected in vertical direction. The two chamber sections are preferably nested.

The load lock chamber is preferably a metal bellows, and elevating means are preferably comprised of a feed screw; a movable member screwed by a feed screw extending vertically and engaged with a bottom of the load lock chamber; if two bellows are used, connecting means; and means for rotating the feed screw.

A vertical type heat treatment apparatus of the present invention contracts by elevating means provided outside, and according to the contraction objects supported by a supporting body are loaded into a treatment chamber, and then transferred therefrom. The outer side of the bottom of the supporing body can be under atmospheric air condition, so that means for rotating the supporting body can be accessed from the exterior.

The elevating means are provided outside the load lock chamber, so that particles caused by the elevation and the like do not penetrate into the chamber.

### Brief description of the Drawings

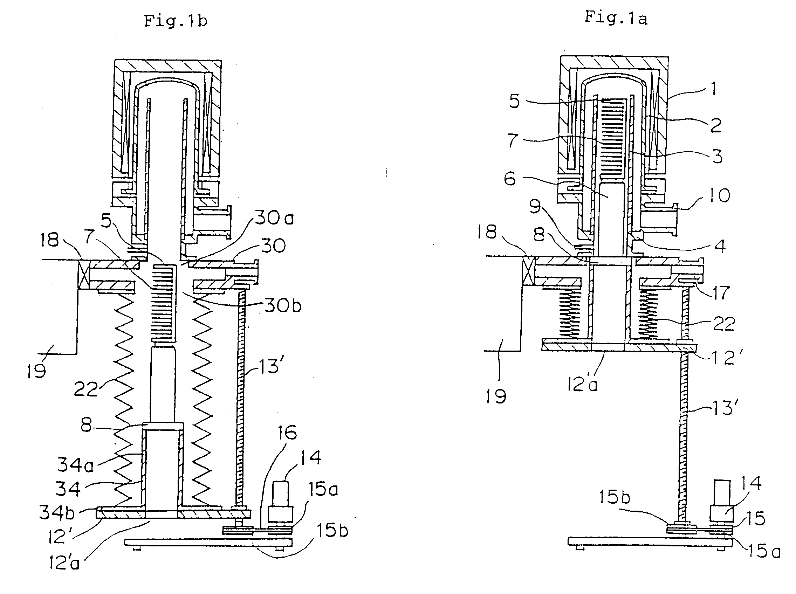

Fig.1a shows a partial cross sectional view of a load lock chamber for a vertical type heat treatment apparatus in accordance with the present invention of which the boat table has been elevated downwardly to its lower position, and Fig. 1b shows a partial cross sectional view of a load lock chamber for a vertical heat treatment apparatus in accordance with the present invention of which the boat table has been elevated downwardly to its lower position.

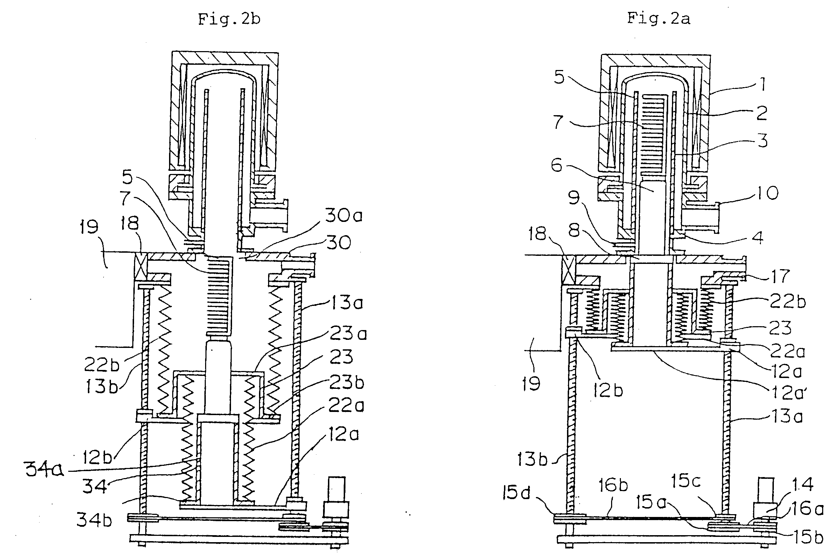

Fig.2a shows a partial cross sectional view of another load lock chamber for a vertical type heat treatment apparatus in accordance with the present invention of which boat table has been elevated upwardly to its upper position, and Fig.2b shows another load lock chamber for a vertical type heat treatment apparatus in accordance with the present invention of which boat table has been elevated downwardly to its lower position.

Fig.3a shows a cross sectional view of a load lock chamber for a vertical type heat treatment apparatus in accordance with the art of which boat table has been elevated upwardly to its upper position, and Fig.2b shows a partial cross sectional view of a load lock chamber for a vertical type heat treatment apparatus in accordance with the art of which boat table has been elevated downwardly until its lower position.

### Preferred Embodiment for carrying out the Invention

Fig.1 shows a partial cross sectional view of a load lock chamber for a vertical type heat treatment apparatus in accordance with the present invention, and Fig.1a shows a state that the load lock chamber has been contracted and Fig.1b shows a state that the load lock chamber has been extended.

The same reference numbers are utilized in the load lock chamber for a vertical type heat treatment apparatus shown in Fig.1, with respect to structural elements commonly used in a load lock chamber for a vertical type heat treatment chamber shown in Fig.3.

In the apparatus shown in Fig.1, an intermediate chamber 30 is mounted below a manifold 4, and the intermediate chamber 30 is communicated with a treatment chamber 1 by an opening 30a of which diameter is larger than a sealing flange 8. Also, the intermediate chamber 30 has an outlet 17 and a room 19 for supplying and removing objects via a gate valve 18, likewise in Fig.3. Moreover, an opening 30b of which diameter is almost the same size as the opening 30a is provided in the intermediate chamber 30.

A cylinder section 34a of which diameter is the same size as the sealing flange 8 and a supporting stand 12 comprising a flange 34b provided on a lower end thereof are mounted below the sealing flange 8 and are communicated through the opening 30b and extended outwardly. While the flange 34b is fixed on a movable member 12', a metal bellows 22 is mounted gastightly between the flange 34 and the intermediate chamber 30 so that the load lock chamber is formed, and a boat table 6 and a supporting boat 5 are isolated from the exterior.

An opening 12'a which has the same size as the inner diameter of the cylinder section 34a is provided in the movable member 12', and the lower surface of the sealing flange 8 is exposed to the exterior. Therefore, a mechanism for rotation can be installed through the sealing flange 8 from the exterior. For example, by communicating rotatably and gastightly a rotational shaft of a motor for the rotational mechanism from the lower part of the sealing flange 8 and by directly connecting the rotational shaft to the boat table 6 positioned above the sealing flange 8, the boat table 6 can be directly rotated externally.

A hole which is threaded, is formed about an end of the movable member 12', and a feed screw 13', which is screwed into the wall outside the bellows 22 and extended in vertical, is provided in capable of rotating in vertical.

A rotation of the motor 14 is transferred to the feed screw 13' by a belt 16 connecting between a pulley 15b provided about the lower end of the feed screw 13' and a pulley 15a provided in the motor 14. While the movable member 12' is elevated by rotating the feed screw 13' so that boat table 6 can be elevated, the bellows 12' follows this elevation so that the interior of the load lock chamber can be maintained in gastight.

Fig.1 shows a state of the load lock chamber when the movable member 12' has been moved to the lowest position. In this position, objects can be placed to or removed from the objects supporting boat.

Fig.2 shows another embodiment of the present invention. This embodiment differs from the embodiment shown in Fig.1, in that two bellows are utilized. Likewise the apparatus of Fig.1, a supporting stand comprising of a cylinder section 34a and a flange 34b is provided below the sealing flange 8, and the flange 34b is mounted on a first movable member 12a having an opening 12a'. The first movable member 12a can be elevated by rotating a first feed screw 13a, as same as in Fig.1.

A first bellows 22a, which has a small diameter and of which lower end is gastightly mounted on the flange 34b, is arranged around the cylinder section 34a of the supporting stand 34. Cylindrical connecting means are positioned outside the bellows 22a, and the upper end of the first bellows 22a is gastightly mounted on a first flange 23a extended inwardly in radial direction in the upper end of the connecting means 23.

The lower end of the connecting means 23 has a flange 23b extending outwardly in the radial direction, and the flange 23b has a hole to screw a second feed screw 13b similar to the first feed screw 13'a and is gastightly mounted on a second movable member 12b which is elevated by rotating a second feed screw 13b. The second movable member 12b has also a central opening section capable of communicating the first bellows 22a.

A second bellows 22b, of which diameter is larger size than the connecting means 23, is gastightly mounted between a lower end of an intermediate chamber 17 and the flange 23b of the connecting means 23 and surrounding the connecting means 23. As mentioned above, by nesting two bellows of which lengths are almost the same, the whole length of the bellows can be reduced. Also, comparing with the bellows of the embodiment of Fig.1, the amount of expansion of each bellows is small, and the life of the bellows can be extended thereby.

As an alternative of this embodiment, the diameter of the first bellows may be larger and the diameter of the second bellows may be smaller. Also, although the whole length is longer, the diameters of two bellows may be set in equal, and they can be connected by the connecting means.

Accordingly, the load lock chamber is formed by the first and the second bellows so that the boat table 6 and the supporting boat 5 are isolated from the exterior.

Supposing that a diameter of a pulley 15c provided below the feed screw 13a is set in one half of a diameter of a pulley 15d provided below the feed screw 13b, each pulley is connected by a belt 16b and a rotation of the motor 14 is transferred to each feed screw, then a traveling speed of the first movable member 12a is twice a traveling speed of the second movable member 12b, so that two bellows can be expanded in the same amount as shown in Fig.2b.

Although it has been exampled that the diameters of two pulleys are adjusted, the expansions of the bellows can be done in the same amount by changing a screw pitch of each feed screw or by providing motor means for rotating each feed screw to adjust the rotation of each of the motor means.

Although the elevation of the movable member has been performed by a feed screw in two embodiments mentioned above, such elevation may be done by elevating means such as air or oil cylinder in stead of the feed screw.

The load lock chamber for a vertical type heat treatment apparatus of the present invention provides means for elevating a boat table supporting objects in the exterior thereof, and the load lock chamber is always maintained in gastight and is not contaminated by particles caused by the elevation thereby.

Moreover, the load lock chamber is made of a flexible member such as a bellows and the elevating means are provided in the exterior, and the volume of the chamber can be reduced thereby.

Furthermore, the sealing flange mounted on the boat table is under atmospheric air condition, and the boat table, that is objects, can easily be rotated by accessing a mechanism for rotating the boat table from the exterior thereby.

## Claims

1. A load lock chamber which can be freely expanded in vertical and is arranged below a treatment chamber of a vertical type heat treatment apparatus, said load lock chamber being able to gastightly load supporting means for supporting objects into said apparatus and unload the supporting means from the apparatus through the lower part of said apparatus, characterized in that:
said load lock chamber is expanded by elevating means provided outside said load lock chamber and said supporting means is mounted in said load lock chamber.

2. A load lock chamber according to claim 1, wherein said load lock chamber is a metal bellows, said elevating means comprising of: a feed screw; a movable member, said movable member being screwed by said feed screw and engaged with said load lock chamber; and means for rotating said feed screw.

3. A load lock chamber, which can be vertically freely expanded and is arranged below a treatment chamber of a vertical type heat treatment apparatus, said load lock chamber being able to gastightly load supporting means for supporting objects into said apparatus and unload the supporting means from the apparatus through the lower part of said apparatus, characterized in that:
said load lock chamber is comprised of an upper and a lower chamber sections, of which sizes are different, and which are connected in vertical, and said load lock chamber is expanded by elevating means provided outside said load lock chamber and said supporting means are mounted in said lower chamber section.

4. A load lock chamber according to claim 3, wherein said upper and said lower chamber sections are cylindrical metal bellows, said upper and said lower chamber sections being connected as a nest by connecting means, so that said elevating means are engaged with said lower chamber section and said connecting means.

## Amended claims

### Amended claims under Art. 19.1 PCT

Cancelled

Cancelled

A load lock chamber, which can be vertically freely expanded and is arranged below a treatment chamber of a vertical type heat treatment apparatus, said load lock chamber being able to gastightly load supporting means for supporting objects into said apparatus and unload the supporting means from the apparatus through the lower part of said apparatus, characterized in that:
said load lock chamber is comprised of an upper and a lower chamber sections, of which sizes are different, and which are connected in vertical, and said load lock chamber is expanded by elevating means provided outside said load lock chamber and said supporting means are mounted in said lower chamber section.

A load lock chamber according to claim 3, wherein said upper and said lower chamber sections are cylindrical metal bellows, said upper and said lower chamber sections being connected as a nest by connecting means, so that said elevating means are engaged with said lower chamber section and said connecting means.
